(19)

**Europäisches Patentamt**
**European Patent Office**
**Office européen des brevets**

(11) **EP 2 847 624 B1**

(12) **EUROPÄISCHE PATENTSCHRIFT**

(45) Veröffentlichungstag und Bekanntmachung des Hinweises auf die Patenterteilung:
**21.03.2018 Patentblatt 2018/12**

(21) Anmeldenummer: **13717753.1**

(22) Anmeldetag: **11.04.2013**

(51) Int Cl.:
***G01V 1/38*** *(2006.01)*

(86) Internationale Anmeldenummer:
**PCT/EP2013/057577**

(87) Internationale Veröffentlichungsnummer:
**WO 2013/167336 (14.11.2013 Gazette 2013/46)**

(54) **VERFAHREN UND VORRICHTUNG ZUM SCHÄTZEN DER FORM EINER AKUSTISCHEN SCHLEPPANTENNE**

METHOD AND APPARATUS FOR ESTIMATING THE SHAPE OF AN ACOUSTIC TOWED ANTENNA

PROCÉDÉ ET DISPOSITIF D'ESTIMATION DE LA FORME D'UNE ANTENNE REMORQUÉE ACOUSTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.05.2012 DE 102012009224**

(43) Veröffentlichungstag der Anmeldung:
**18.03.2015 Patentblatt 2015/12**

(73) Patentinhaber: **ATLAS ELEKTRONIK GmbH**
**28309 Bremen (DE)**

(72) Erfinder: **SCHULZ, Florian**
**44799 Bochum (DE)**

(74) Vertreter: **Weidner Stern Jeschke**
**Patentanwälte Partnerschaft**
**Universitätsallee 17**
**28359 Bremen (DE)**

(56) Entgegenhaltungen:
• **D.A Gray ET AL: "Towed array shape estimation using Kalman filters-theoretical models", IEEE Journal of Oceanic Engineering, 1. Januar 1993 (1993-01-01), Seiten 543-556, XP055116052, DOI: 10.1109/48.262304 Gefunden im Internet: URL:http://ieeexplore.ieee.org/xpls/abs_all.jsp?arnumber=262304**

• **J.L Riley ET AL: "Towed array shape estimation using Kalman filters-experimental investigations", IEEE Journal of Oceanic Engineering, 1. Januar 1993 (1993-01-01), Seiten 572-581, XP055116054, DOI: 10.1109/48.262307 Gefunden im Internet: URL:http://ieeexplore.ieee.org/xpls/abs_all.jsp?arnumber=262307**

• **Esme Bilgin: "Bilgin's Blog | Kalman Filter for Dummies", , 31. März 2009 (2009-03-31), XP055121756, Gefunden im Internet: URL:http://bilgin.esme.org/BitsBytes/KalmanFilterforDummies.aspx [gefunden am 2014-06-04]**

• **NIKITAS V NIKITAKOS ET AL: "Towed Array Shape Estimation Using Multimodel Partitioning Filters", IEEE JOURNAL OF OCEANIC ENGINEERING, IEEE SERVICE CENTER, PISCATAWAY, NJ, US, Bd. 23, Nr. 4, 1. Oktober 1998 (1998-10-01), XP011042449, ISSN: 0364-9059**

• **TICHAVSKY P ET AL: "Quasi-Fluid-Mechanics-Based Quasi-Bayesian CramÉr-Rao Bounds for Deformed Towed-Array Direction Finding", IEEE TRANSACTIONS ON SIGNAL PROCESSING, IEEE SERVICE CENTER, NEW YORK, NY, US, Bd. 52, Nr. 1, 1. Januar 2004 (2004-01-01) , Seiten 36-47, XP011104127, ISSN: 1053-587X, DOI: 10.1109/TSP.2003.820072**

- W. BRANDENBURG ET AL: "A point mechanical model for the dynamics of towed arrays", ICASSP '84. IEEE INTERNATIONAL CONFERENCE ON ACOUSTICS, SPEECH, AND SIGNAL PROCESSING, Bd. 9, 1. Januar 1984 (1984-01-01), Seiten 194-197, XP055116037, DOI: 10.1109/ICASSP.1984.1172768

- B.K. NEWHALL ET AL: "Improved estimation of the shape of towed sonar arrays", PROCEEDINGS OF THE 21ST IEEE INSTRUMENTATION AND MEASUREMENT TECHNOLOGY CONFERENCE (IEEE CAT. NO.04CH37510), 18. Mai 2004 (2004-05-18), Seiten 873-876, XP055116060, DOI: 10.1109/IMTC.2004.1351201

**Beschreibung**

Die Erfindung betrifft ein Verfahren zum Schätzen der Form einer akustischen Schleppantenne mit einer Kalman-Filterung nach dem Oberbegriff von Anspruch 1 sowie eine Vorrichtung zur Schätzung der Form einer akustischen Schleppantenne mit einer Kalman-Filterung nach dem Oberbegriff von Anspruch 15.

Beispielsweise in "Towed Array Shape Estimation Using Kalman-Filters - Theoretical Models", IEEE Journal of Oceanic Engineering, vol. 18, no. 4, S. 543-556, 1987, D.A. Gray, B.D.O. Anderson and R.R. Bitmead, wird ein Verfahren zur Schätzung der Form einer Schleppantenne vorgestellt. Bei dem vorgestellten Verfahren wird die Form der Schleppantenne anhand von Messwerten der in einer Schleppantenne eingebauten Tiefensensoren und Kompassen mit einer Kalman-Filterung geschätzt.

Bei dem betrachteten Verfahren wird, um die Kalman-Filterung einsetzen zu können, eine Schleppantenne vorausgesetzt, die aus einem homogenen dünnen, flexiblen und neutral getrimmten zylinderförmigen Schwimmkörper besteht, wobei der Schwimmkörper akustische Sensoren aufweist. Der Schwimmkörper entspricht somit der Akustiksektion einer realen Schleppantenne. Der Kopf des Schwimmkörpers wird ferner als Zugpunkt und dessen Zugpunktbewegung als bekannt vorausgesetzt. Ferner wird die Voraussetzung getroffen, dass die Zugpunktbewegungen gleichförmig und geradlinig sind.

Das vorgestellte Schätzverfahren stellt ein geeignetes Verfahren zur Schätzung der Form einer Schleppantenne dar, wobei die Schätzung nur für die durch die o.g. Vorraussetzungen vorgegebenen Spezialfälle möglich ist. Diese Spezialfälle sind solange erfüllt, wie das die Schleppantenne schleppende Fahrzeug lediglich klassische "straight course-Manöver" durchführt.

Im realen Fall wird die Akustiksektion bzw. der Schwimmkörper jedoch mit einem Zugseil durch ein Gewässer gezogen. Dann ist von einem Zugpunkt auszugehen, der nicht dem Kopf der Akustiksektion bzw. des Schwimmkörpers, sondern der Schnittstelle zwischen dem die Schleppantenne schleppenden Fahrzeug und dem Zugseil entspricht. Hier fehlt es dann bereits an einer der Vorraussetzung für die Formschätzung mit der Kalman-Filterung, da in diesem Fall nicht mehr von einem homogenen Schwimmkörper auszugehen ist. Das Schleppseil und die Akustiksektion weisen nämlich unterschiedliche physikalische Eigenschaften auf. Ferner ist gerade bei beliebigen Kurvenfahrten eine Formschätzung der Schleppantenne nötig, um auch bei diesen Kurvenfahrten die Anordnung der akustischen Sensoren zu kennen, da nur so aufgenommene Schallsignale zuverlässig verarbeitet werden können.

In dem Artikel "Towed array shape estimation using Kalman filters - experimental investigations" von Riley et al., IEEE Journal of Oceanic Engineering, 1. Januar 1993, S. 572-581 wird die Anwendung von Kalman-Filtern zur Schätzung der Form einer Schleppantenne. Die Zustandsraumdarstellung wird von einem dynamischen Modell der Fortsetzung der zugpunktinduzierten Bewegung bis zur Antenne abgeleitet

In dem Artikel "Improved estimation of the shape of towed sonar arrays" von Newhall et al., Proceedings of the 21st IEEE Instrumentation and measurement technology conference, 18. Mai 2004, S. 873-876 wird zur Schätzung der Form einer Schleppantenne die Verwendung eines Kalman-Filters unter Verwendung von zwölf Kurssensoren an der Antenne sowie der Geschwindigkeit und des Kurses des Fahrtweges des Schleppbootes beschrieben.

In "A Point Mechanical Model for the Dynamics of Towed Arrays" von W. Brandenburg in IEEE International Conference on ICASSP, Vol. 9, Part. 1, S.194-197, 1984 wird ein mechanisches Modell für das dynamische Verhalten einer Schleppantenne offenbart. Dabei ist die Schleppantenne durch eine Kette von Massepunkten beschrieben, wobei jeder Massepunkt ein Segment der Schleppantenne repräsentiert.

In dem Artikel "Quasi-fluid-mechanics-based-Bayesian Cramer-Rao bounds for deformed towed-array direction finding" von Tichavski und Wong, IEEE Transyctions on Signal Processing, Vol. 52, Issue 1, S36-47, 2004 wird ein Verfahren offenbart, bei dem das dynamische Verhalten einer Schleppantenne ausgehend von einer Paidoussis Gleichung beschrieben wird. Zusätzlich werden Varianzen der Zugpunkt-Bewegung und der Meeresdynamik in einem Quasi Bayes'schen Filter berücksichtigt.

In dem Artikel "Towed array shape estimation using multimodel partitioning filters" von Nikitakos et al., IEEE Journal of Oceanic Engineering, 1. Oktober 1998, S. 380-384 wird ein adaptiver Multimodell-Verteilungsalgorithmus zur Schätzung der Form einer Schleppantenne vorgeschlagen und mit der alleinigen Anwendung des Kalman-Filters verglichen.

Der Erfindung liegt daher die Aufgabe zugrunde eine Schätzung der Form einer Schleppantenne mit einer Kalman-Filterung zu finden, die auch unter realen Bedingungen ohne die o.g. einschränkenden Voraussetzungen anwendbar ist.

Die Erfindung löst diese Aufgabe durch ein Verfahren zum Schätzen der Form einer akustischen Schleppantenne mit einer Kalman-Filterung nach Anspruch 1 sowie durch eine Vorrichtung zur Schätzung der Form einer akustischen Schleppantenne mit einer Kalman-Filterung nach Anspruch 15.

Gemäß der Erfindung wird die Form einer akustischen Schleppantenne mit einer üblichen Kalman-Filterung, also mit den als Kalman-Filter bekannten Gleichungen, geschätzt. Hierbei wird jedoch im Gegensatz zur üblichen Anwendung der Gleichungen zunächst der deterministische Anteil der Zustandsgleichung des Kalman-Filters zu Null gesetzt.

Ferner werden zusätzlich zu den bei der Kalman-Filterung durchgeführten Berechnungen aufeinanderfolgende diskrete Zeitpunkte vordefiniert und eine geschätzte Form der Schleppantenne in den vordefinierten Zeitpunkten jeweils durch einen modellbasierten Zustandsvektor beschrieben. Diese modellbasierten Zustandsvektoren werden in den jeweiligen Zeitpunkten durch das geschätzte zeitliche Verhalten eines mechanischen Modells der Schleppantenne und durch als bekannt vorausgesetzte Bewegungen eines beliebigen als Zugpunkt definierten Punktes der Schleppantenne ermittelt. Dieser Zugpunkt entspricht z.B. der Schnittstelle zwischen einem die Schleppantenne schleppenden Fahrzeug und einem Zugseil der Schleppantenne, wobei dann durch bekannte Kursmanöver des Fahrzeugs immer die Position bzw. die Bewegung des Zugpunktes bekannt ist.

Ferner wird die Schleppantenne als in mehrere Segmente eingeteilt angenommen. Ein aktueller modellbasierter Zustandsvektor eines Zeitpunktes weist dann geschätzte Werte der aktuellen Positionen, Ausrichtungen und/oder Formen mehrerer oder aller der Segmente bzw. aus diesen Werten abgeleitete Werte auf. Diese Werte bzw. diese aus den Werten abgeleiteten Werte werden mit dem mechanischen Modells der Schleppantenne und der Zugpunktbewegung ermittelt.

Ferner wird jeweils einer der vordefinierten Zeitpunkte, in dem die Form der Schleppantenne mit der Kalman-Filterung geschätzt werden soll, als aktueller Zeitpunkt ausgewählt. Der modellbasierte Zustandsvektor des jeweils aktuellen Zeitpunktes wird als aktueller modellbasierter Zustandsvektors bezeichnet. Ferner wird die Abweichung des jeweils aktuellen modellbasierten Zustandsvektors zu einem oder mehreren vorhergehenden, also zu vorhergehenden Zeitpunkten ermittelten, modellbasierten Zustandsvektoren bestimmt. Diese Abweichung beschreibt dann die zeitliche Änderung des mechanischen Modells aufgrund auf die Schleppantenne ausgeübter Kräfte, z.B. durch Zugpunktbewegungen, Strömungen, Erdbeschleunigung oder Auftrieb. Die jeweilige aktuell bestimmte Abweichung wird dann als Matrix betrachtet bzw. in eine Matrix überführt oder als Matrix dargestellt und diese Matrix in die Übergangsmatrix für die Kalman-Filterung überführt, sodass die Übergangsmatrix für die Kalman-Filterung durch die mit dem mechanischen Modell ermittelten Matrizen periodisch aktualisiert wird.

Das deterministische dynamische Verhalten der Schleppantenne wird also nicht mehr, wie bei der üblichen Kalman-Filterung, durch den deterministischen Term bei der Kalman-Filterung beschrieben, da gemäß der Erfindung die Übergangsmatrix, die mit einem mechanischen Modell der Schleppantenne ermittelt wird, das deterministische dynamische Verhalten beschreibt. Die bei der üblichen Kalman-Filterung zeitinvariante Übergangsmatrix wird also gemäß der Erfindung wiederholt aktualisiert.

Aufgrund eines beliebig wählbaren mechanischen Modells sind dank der Erfindung beliebige Zugpunktbewegungen und physikalische Eigenschaften der Schleppantenne möglich. Zudem kann der Zugpunkt der Schleppantenne an einer beliebigen Position angenommen werden, wobei trotz alledem eine Kaiman-Filterung angesetzt werden kann.

Gemäß einer bevorzugten Ausführungsform werden mit der Kalman-Filterung kalmanbasierte Zustandsvektoren periodisch ermittelt. Hierbei weist der zu einem aktuellen Zeitpunkt der vordefinierten Zeitpunkte aktuelle kaimanbasierte Zustandsvektor geschätzte Werte der aktuellen Positionen, Ausrichtungen und/oder Formen mehrerer oder aller der Segmente oder aus den Werten abgeleitete Werte auf.

Dank der kaimanbasierten Zustandsvektoren, aus denen sich direkt Positionen, Ausrichtungen und/oder Formen von Segmenten der Schleppantenne ermitteln lassen, ist eine einfache Schätzung der aktuellen Form der Schleppantenne möglich.

Gemäß einer weiteren bevorzugten Ausführungsform wird bei der Kaiman-Filterung ein aktueller kalmanbasierter Zustandsvektor mit einem Prädiktionsschritt und einem auf den Prädiktionsschritt folgenden Korrekturschritt ermittelt. Hierbei wird im Prädiktionsschritt zunächst ein aktueller unkorrigierter kalmanbasierter Zustandsvektor ermittelt, indem ein oder mehrere vorher bestimmte kalmanbasierte Zustandsvektoren mit der Übergangsmatrix multipliziert werden. Daraufhin wird der aktuelle unkorrigierte kalmanbasierte Zustandsvektor im Korrekturschritt in den aktuellen kalmanbasierten Zustandsvektor überführt.

Durch Multiplikation des oder der kalmanbasierten Zustandsvektoren, die vor dem jeweiligen aktuellen kalmanbasierten Zustandsvektor bestimmt wurden, mit der Übergangsmatrix, die mittels dem mechanischen Modell der Schleppantenne ermittelt wurde, wird im Prädiktionsschritt ein Ergebnis für die geschätzte Form der Schleppantenne geliefert, das bereits das deterministische dynamische Verhalten der Schleppantenne berücksichtigt und daher eine Grundlage für eine Verbesserung im Korrekturschritt bietet.

Gemäß einer weiteren bevorzugten Ausführungsform weist eines oder weisen mehrere der Segmente jeweils einen oder mehrere Sensoren auf. Die Sensoren dienen zur Ermittlung von Messwerten der Messgrößen Position, Ausrichtung und/oder Form des jeweiligen Segments und zur Ausgabe der ermittelten Messwerte. Die Messwerte der gleichen Messgröße im aktuellen Zeitpunkt der definierten Zeitpunkte werden bei der Ausgabe in einem aktuellen Messvektor dieser Messgröße dargestellt. Im Korrekturschritt der Kalman-Filterung wird dann der aktuelle kaimanbasierte Zustandsvektor ermittelt, indem die Differenz zwischen dem oder den aktuellen Messvektoren einer oder mehrere Messgrößen und dem aktuellen unkorrigierten kaimanbasierten Zustandsvektor ermittelt und durch Multiplikation mit einer aktuellen Kalman-Matrix gewichtet wird. Das Produkt wird durch Addition mit dem aktuellen unkorrigierten kaimanbasierten Zustandsvektor in den aktuellen kaimanbasierten Zustandsvektor überführt.

Dank der Messwerte der Sensoren, die im Korrekturschritt der Kalman-Filterung verwendet werden, wird eine Korrektur des unkorrigierten kaimanbasierten Zustandsvektors möglich.

Gemäß einer weiteren bevorzugten Ausführungsform wird die aktuelle Kalman-Matrix mit der aktuellen Kovarianzmatrix des Schätzfehlers des aktuellen unkorrigierten kalmanbasierter Zustandsvektors ermittelt. Hierbei wird die Kovarianzmatrix des Schätzfehlers des aktuellen unkorrigierten kaimanbasierten Zustandsvektors mit der aktuellen Übergangsmatrix und der Kovarianzmatrix des Schätzfehlers des zeitlich vorher ermittelten kalmanbasierten Zustandsvektors ermittelt.

Durch die Ermittlung der aktuellen Kalman-Matrix mit den Kovarianzmatrizen geht ein Unsicherheitsmaß der zuvor ermittelten kaimanbasierten Zustandsvektoren in die Kalman-Matrix ein, um bei Ermittlung des aktuellen kaimanbasierten Zustandsvektors möglichst realistische Vorraussetzungen zu berücksichtigen.

Gemäß einer weiteren bevorzugten Ausführungsform werden Störungen der Sensoren mit dadurch fehlerbehafteten Messwerten der Sensoren angenommen. Für die Messwerte wird daher zudem eine Kovarianzmatrix des Fehlers dieser Messwerte einmalig zu Beginn der Schätzung oder regelmäßig neu ermittelt. Diese Kovarianzmatrix wird zusätzlich bei der Ermittlung der Kalman-Matrix berücksichtigt.

Durch die Ermittlung und Berücksichtigung der Kovarianzmatrix des Fehlers der Messwerte der Sensoren geht ein Unsicherheitsmaß der Messwerte in die Kaiman-Matrix ein, um die Ermittlung des aktuellen kaimanbasierten Zustandsvektors zu verbessern.

Gemäß einer weiteren bevorzugten Ausführungsform werden die Messwerte der Sensoren geglättet. Dadurch ergibt sich der Vorteil, dass weniger stark streuende Messwerte zu entsprechend weniger stark streuenden Ergebnissen der Kaiman-Filterung führen.

Gemäß einer weiteren bevorzugten Ausführungsform wird eine Kovarianzmatrix eines angenommenen additiven Prozessrauschens zu Beginn der Formschätzung einmalig oder regelmäßig, z.B. in vordefinierten Intervallen, bestimmt und zur Bestimmung der Kovarianzmatrix des Schätzfehlers des jeweiligen unkorrigierten kaimanbasierten Zustandsvektors herangezogen.

Gemäß einer weiteren bevorzugten Ausführungsform wird zu Beginn der Schätzung der Form ein erster kalmanbasierter Zustandsvektor zur Bestimmung darauffolgender kalmanbasierter Zustandsvektoren und ein erster modellbasierter Zustandsvektor zur Bestimmung darauffolgender modellbasierter Zustandsvektoren anhand einer vermuteten Form der Schleppantenne ermittelt. Es wird also von einer Form der Schleppantenne, insbesondere einer geradlinigen Form nach Geradeausfahrt des die Schleppantenne schleppenden Fahrzeugs, ausgegangen, die vermuteter Weise der realen Form entspricht, diese Form wird durch den ersten kaimanbasierten Zustandsvektor und den ersten modellbasierten Zustandsvektor dargestellt und auf diese ersten Zustandsvektoren die weiterer Formschätzung gestützt.

Dank der Darstellung der vermuteten Form der Schleppantenne durch den ersten kaimanbasierten Zustandsvektor und den ersten modellbasierten Zustandsvektor ist eine Initialisierung der Formschätzung möglich.

Gemäß einer weiteren bevorzugten Ausführungsform berücksichtigt das mechanische Modell der Schleppantenne ein Feder-Masse-System. Bei dem Feder-Masse-System werden ein oder mehrere Punkte, z.B. Schwerpunkte oder beliebige andere Punkte, jeweils für jedes Segment der Schleppantenne als Masse definiert. Benachbarte Massen werden als durch Federn mit vordefinierten Federkonstanten, also elastisch, miteinander verbunden betrachtet. Das geschätzte zeitliche Verhalten des mechanischen Modells der Schleppantenne wird dann durch Beschleunigungen der Massen ermittelt, die durch Federkräfte sowie durch äußere Kräfteeinwirkungen auf das Feder-Masse-System erzeugt werden. Äußere Kräfteeinwirkungen sind z.B. hydrodynamische Kräfte, durch verdrängte Flüssigkeit verursachte Gegenkräfte sowie statische Auftriebskräfte.

Vorteilhafterweise können durch ein derartiges mechanisches Modell beliebige physikalische Eigenschaften der Schleppantenne in einfacher Weise berücksichtig werden.

Gemäß einer weiteren bevorzugten Ausführungsform werden zyklische Werte der modellbasierten Zustandsvektoren, wie z.B. Kompasswerte, die die geschätzten Ausrichtungen der Segmente angeben, vor der Überführung in die Übergangsmatrix in äquivalente lineare Werte umgewandelt. Ferner werden zyklische Messwerte der Messvektoren vor der Bestimmung der Abweichung zwischen dem Messvektor und dem aktuellen unkorrigierten kaimanbasierten Zustandsvektor in äquivalente lineare Messwerte umgewandelt. Eine Umwandlung ist, z.B. im Falle von in den Zustands- bzw. Messvektoren enthaltenen Kompasswerten der Segmente, dadurch möglich, dass die Werte einzeln einer modifizierten Moduloberechnung unterzogen werden.

Dadurch ist es möglich, dass in dem Falle, dass sich innerhalb eines Zeitschritts ein Wert im Zustands- oder Messvektor über seine zyklische Grenze hinwegbewegt, dies nicht zu sehr großen Differenzbeträgen, z.B. in der Übergangsmatrix oder im aktuellen kaimanbasierten Zustandsvektor, führt. Diese großen Differenzbeträge würden nämlich zu fehlerbehafteten kaimanbasierten Zustandsvektoren führen und die Formschätzung verfälschen.

Gemäß einer weiteren bevorzugten Ausführungsform ist der zeitliche Abstand zwischen den vordefinierten Zeitpunkten kürzer als der zeitliche Abstand zwischen den Zeitpunkten, in denen die Position des Zugpunktes ermittelt wird. Ferner werden dann aktuelle Positionen des Zugpunktes, die zeitlich zwischen den ermittelten Zeitpunkten liegen, durch Interpolation ermittelt.

Hierdurch ergibt sich der Vorteil, dass die Position des Zugpunktes nicht zu jedem Zeitpunkt der definierten Zeitpunkte aktuell ermittelt werden muss, sondern dass eine Ermittlung der Position des Zugpunktes auch mit einer geringeren Widerholfrequenz bzw. Periode möglich ist.

Gemäß einer weiteren bevorzugten Ausführungsform werden kaimanbasierte Zustandsvektoren mit einer geringeren Wiederholrate ermittelt als modellbasierte Zustandsvektoren.

Hierdurch kann Rechenaufwand und damit elektrischer Energieaufwand bei der Durchführung des Verfahrens bzw. der erfindungsgemäßen Vorrichtung eingespart werden.

Gemäß einer weiteren bevorzugten Ausführungsform weisen die Messvektoren, die modellbasierten Zustandsvektoren und die kaimanbasierten Zustandsvektoren nur diskrete Werte geschätzter Positionen, Ausrichtungen und/oder Formen oder diskrete aus diesen Werten abgeleitete Werte auf. Diese Wertdiskretisierung der Zustands- und Messgrößen ergibt sich z.B. durch eine räumliche Diskretisierung des zu betrachtenden Raumes, in dem die Form der Schleppantenne geschätzt werden soll. Abgeleitete Werte entsprechen hier Werten, die durch mathematische Methoden, wie z.B. durch Multiplikation mit Konstanten oder Moduloberechnung, von den tatsächlichen Werten der geschätzten Positionen, Ausrichtungen und/oder Formen abgeleitet sind.

Durch Diskretisierung der Werte lässt sich weiterer Rechenaufwand und damit elektrischer Energieaufwand bei der Durchführung des Verfahrens bzw. der erfindungsgemäßen Vorrichtung einsparen, da eine digitale Bearbeitung möglich ist.

Weitere Ausführungsformen der Erfindung ergeben sich aus den Unteransprüchen sowie aus den anhand der Zeichnung näher erläuterten Ausführungsbeispielen. In der Zeichnung zeigen:

Fig. 1     Draufsicht auf ein Wasserfahrzeug mit einer Schleppantenne,

Fig. 2     ein mechanisches Modell der Schleppantenne aus Fig. 1,

Fig. 3     einen Ablauf der Kalman-Filterung und

Fig. 4     den Ablauf eines Ausführungsbeispiels des erfindungsgemäßen Verfahrens.

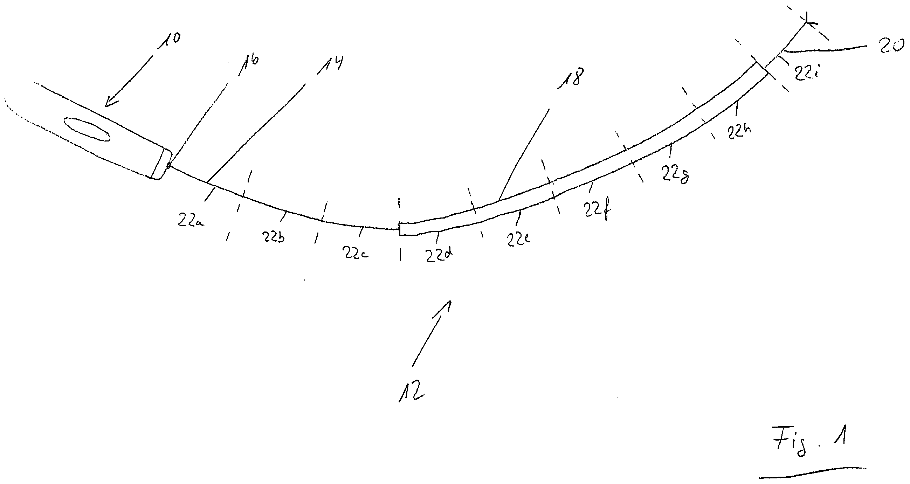

Fig. 1 zeigt die Draufsicht auf ein Wasserfahrzeug 10 mit einer Schleppantenne 12. Die Schleppantenne 12 umfasst ein Zugseil 14, das an einer Schnittstelle 16, die als Zugpunkt 16 definiert ist, am Wasserfahrzeug 10 befestigt ist. Am gegenüberliegenden Ende des Zugpunktes 16 ist eine Akustiksektion 18 mit dem Zugseil 14 verbunden. Am Ende weist die Schleppantenne ein Endstück 20 auf. Ferner kann eine reale Schleppantenne noch weitere Sektionen, wie z.B. Schwingungsdämpfer zwischen dem Zugseil 14 und der Akustiksektion 18 sowie zwischen der Akustiksektion 18 und dem Endstück 20, aufweisen, die zur besseren Übersicht allerdings nicht dargestellt sind. Die Schleppantenne wird nun als in Segmente 22 eingeteilt angenommen. In Fig. 1 ist eine Einteilung der Schleppantenne 12 in Segmente 22a bis 22i vorgenommen worden, wobei jede beliebig gröbere oder feinere Einteilung der Schleppantenne 12 möglich ist.

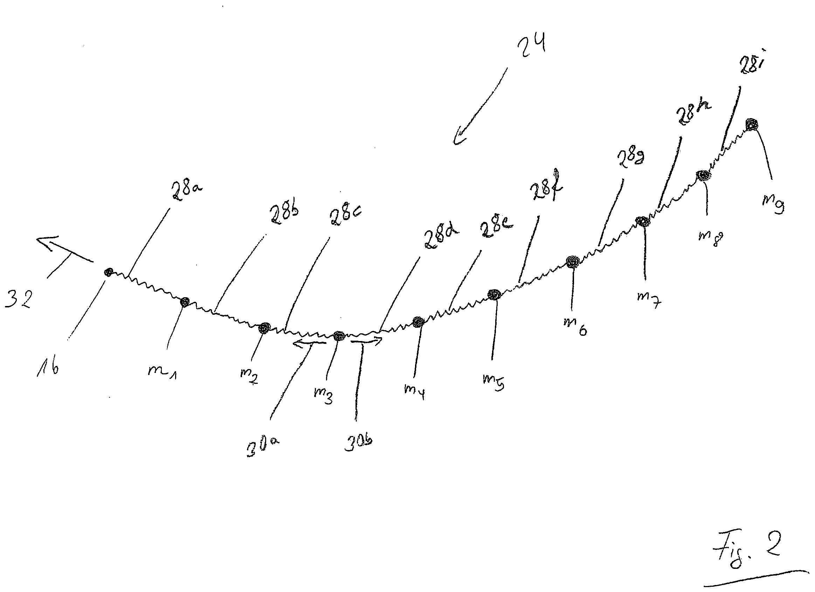

Fig. 2 zeigt ein mechanisches Modell 24 der Schleppantenne 12 aus Fig. 1. Das mechanische Modell 24 weist den Zugpunkt 16 sowie die Massen $m_1$ bis $m_9$ auf, die durch Federelemente bzw. Federn 28a bis 28i elastisch verbunden sind. Die Massen $m_1$ bis $m_9$ sind abhängig vom Segment, das durch die jeweilige Masse modelliert wird, gleich oder unterschiedlich groß. Ferner sind auch die Federkonstanten der Federn 28a bis 28i abhängig vom Segment, das durch die jeweilige Feder modelliert wird, gleich oder unterschiedlich groß. Geht man z.B. davon aus, dass die Akustiksektion 18 aufgrund ihres Aufbaus eine höhere Elastizität in Längsrichtung als das Zugseil 14 aufweist, ergeben sich allein hierdurch unterschiedliche Federkonstanten der Federn, wegen denen die Segmente 22 dieser beiden unterschiedlichen Sektionen der Schleppantenne 12 unterschiedlich modelliert werden müssen.

Allgemein wird im Folgenden von $n$ Massen $m$ ausgegangen, die $n$ Segmente 22 beschreiben. Die $n$-te Masse $m_n$ des $n$-ten Segments 22 des mechanischen Modells 24 wird dann z.B. durch die Formel

$$m_n = \rho_n l_n \pi \frac{d_n^2}{4}$$

ermittelt, wobei $\rho_n$ die Dichte des $n$-ten Segments 22, $l_n$ die Länge des $n$-ten Segments 22 und $d_n$ den Durchmesser des $n$-ten Segments 22 beschreibt.

Geht man nun von Kräften aus, die auf die Masse $m_n$ wirken und die zusammengefasst als Gesamtkraft $F_{n,ges}$ bezeichnet werden, so kann mit der Formel

$$\frac{F_{n,ges}}{m_n} = a_n$$

die Beschleunigung $a_n$ der Masse $m_n$ bestimmt werden. Die Gesamtkraft $F_{n,ges}$ setzt sich aus beliebigen im mechanischen Modell 24 zu berücksichtigenden Kräfte zusammen, die auf die jeweilige modellierte Schleppantenne 12 wirken. Wichtigste hierbei zu berücksichtigende Kraft ist die Zugkraft 32 des Zugpunktes 16. Weitere Kräfte sind z.B. die Gewichtskräfte der Segmente und die Zugkräfte 30a, 30b, die durch Beschleunigung eines benachbarten Segments 22 auf ein Segment 22 wirken. Ferner werden z.B. die Auftriebskräfte der Segmente 22 und die Gegenkräfte, die auf die Segmente 22 wirken, wenn diese bei der Bewegung durch ein Gewässer Wasser verdrängen, berücksichtigt.

Ferner werden die Massen $m$ des mechanischen Modells 24 in einem Zeitpunkt $k_0$ durch eine bekannte Position $r_n(k_0)$ und eine bekannte Geschwindigkeit $v_n(k_0)$ der Massen $m$ initialisiert. Außerdem werden zusätzlich auf den Zeitpunkt $k_0$ folgende Zeitpunkte $k_i$ vordefiniert, wobei zeitlich aufeinanderfolgende Zeitpunkte einen zeitlichen Abstand $\Delta t$ aufweisen. Damit wird dann die Geschwindigkeit $v_n(k_1)$ der Masse $m_n$ des $n$-ten Segments 22 zum Zeitpunkt $k_1$ durch

$$v_n(k_1) = v_n(k_0) + a_n(k_0) \cdot \Delta t$$

ermittelt. Mit der ermittelten Geschwindigkeit $v_n(k_1)$ kann dann die Geschwindigkeit $v_n(k_2)$ im darauffolgenden Zeitpunkt und entsprechend die weiteren Geschwindigkeiten für weitere Zeitpunkte $k_i$ bestimmt werden.

Ferner wird anhand der ermittelten Geschwindigkeit $v_n(k_1)$ im Zeitpunkt $k_1$ und der zum vorhergehenden Zeitpunkt $k_0$ bekannten Position $r_{n,0}(k_0)$ die Position der Masse $m_n$ des $n$-ten Segments 22 im Zeitpunkt $k_1$ durch

$$r_n(k_1) = r_n(k_0) + v_n(k_1) \cdot \Delta t$$

ermittelt. Mit der ermittelten Position $r_n(k_1)$ kann dann die Position $r_n(k_2)$ im darauffolgenden Zeitpunkt und entsprechend die weiteren Positionen für weitere Zeitpunkte $k_i$ bestimmt werden. Die Positionen $r_n(k)$ entsprechen z.B. absoluten Koordinaten oder Vektoren zur jeweiligen Masse $m_n$ ausgehend von einem für alle Massen gewählten beliebigen Referenzpunkt.

Die o.g. Gleichungen beschreiben die Aktualisierung des Bewegungszustandes des mechanischen Modells 24 der Schleppantenne 12 unter Verwendung eines expliziten Integrationsansatzes. Hierbei handelt es sich um ein Ausführungsbeispiel, wobei die Ermittlung von Beschleunigungs-, Geschwindigkeits- und/oder Orts- bzw. Positionsvektoren nicht auf diese Methode beschränkt ist. Insbesondere sind auch implizite Integrationsverfahren möglich, deren Aktualisierungsvorschriften zwar aufwendiger und weniger intuitiv sind, die in der Umsetzung aber dafür Geschwindigkeitsvorteile erzielen.

Mit dem mechanischen Modell 24 wird so zu jedem Zeitpunkt $k_i$ die Position der Massen $m_n$ und damit der Segmente 22 bestimmt. Die Positionen der Massen $m_n$ werden dann in einem modellbasierten Zustandsvektor $x$ jeweils für jeden der Zeitpunkte $k_i$ dargestellt. Der modellbasierte Zustandsvektor $x(k_1)$ für die Zeitpunkte $k_i$ des in Fig. 1 dargestellten Modells mit den Massen $m_1$ bis $m_9$, entspricht dann

$$x(k_i) = \begin{bmatrix} r_{m_1}(k_i) \\ r_{m2}(k_i) \\ ... \\ ... \\ r_{m9}(k_i) \end{bmatrix}.$$

Die Abweichung eines aktuellen modellbasierten Zustandsvektors $x(k_i)$, also des Zustandsvektors $x(k_i)$ des aktuellen Zeitpunktes, zum vorhergehenden modellbasierten Zustandsvektor $x(k_{i-1})$, also des vorhergehenden Zeitpunktes, wird dann in eine aktuelle Matrix $\tilde{F}(k_i)$ des aktuellen Zeitpunktes $k_i$ überführt, sodass die Gleichung

$$x(k_i) = \tilde{F}(k_i) \cdot x(k_{i-1})$$

erfüllt ist. Die aktuelle Matrix $\tilde{F}(k_i)$, also die Matrix $\tilde{F}(k_i)$ des aktuellen Zeitpunktes, ist somit für jeden der Zeitpunkte $k_i$

bestimmbar.

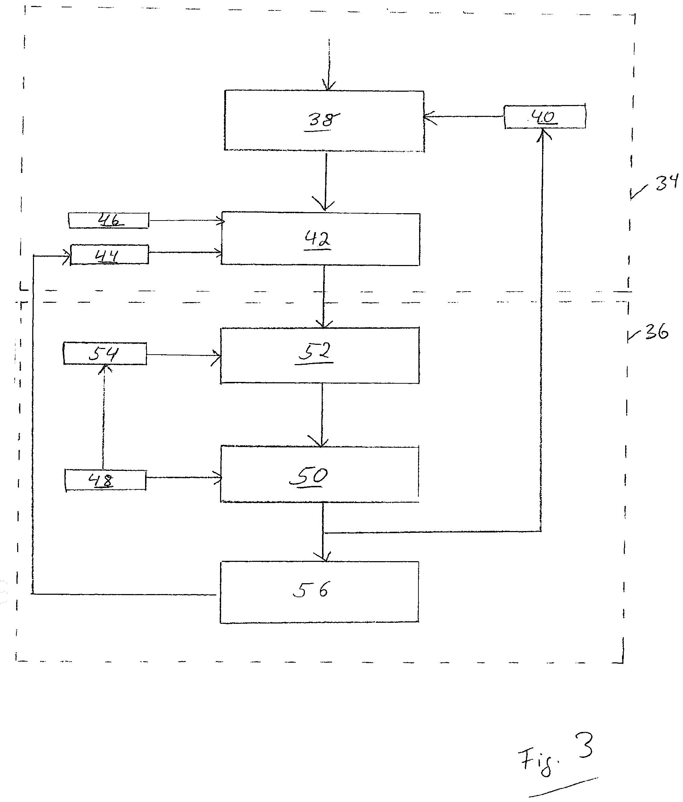

Fig. 3 zeigt zum besseren Verständnis der Erfindung den bekannten Ablauf der Kalman-Filterung zur Schätzung der Form einer Schleppantenne 12. Die Kaiman-Filterung besteht aus mehreren Gleichungen, die dazu dienen, Messwerte von in einem oder mehreren der Segmente 22 angeordneten Sensoren, die zur Ermittlung von Messwerten der Messgrößen Position, Ausrichtung und/oder Form des jeweiligen Segments dienen, bei der Formschätzung zu berücksichtigen. Ferner ist durch die Kalman-Filterung ein Entfernen bzw. Reduzieren von Störungen der Sensoren möglich.

Bei der Kalman-Filterung werden dazu Zustandsvektoren $\hat{x}$ für einen aktuellen Zeitpunkt $k_i$ geschätzt. Um eine Verwechslung mit den o.g. modellbasierten Zustandsvektoren $x$ zu vermeiden, werden vorliegend die Zustandsvektoren $\hat{x}$, die bei der Kalman-Filterung verwendet werden, kaimanbasierte Zustandsvektoren $\hat{x}$ genannt. Die kaimanbasierten Zustandsvektoren $\hat{x}$ sind jedoch mit den modellbasierten Zustandsvektoren $x$ zu vergleichen, da auch ein kalmanbasierter Zustandsvektor $\hat{x}$ in einem Zeitpunkt $k$, für den der jeweilige kaimanbasierte Zustandsvektor $\hat{x}$ bestimmt wurde, die geschätzte Form der Schleppantenne 12 beschreibt.

Ein aktueller kalmanbasierter Zustandsvektor $\hat{x}(k_i)$ eines beliebigen aktuellen Zeitpunktes $k_i$ wird bei der Kalman-Filterung in zwei Schritten aus einem kalmanbasierter Zustandsvektor $\hat{x}(k_{i-1})$ des dem aktuellen Zeitpunkt $k_i$ vorhergehenden Zeitpunktes $k_{i-1}$ ermittelt. Der erste dieser beiden Schritte wird Prädiktionsschritt 34 und der zweite dieser Schritte wird Korrekturschritt 36 genannt. Diese beiden Schritte werden iterativ wiederholt.

Im Prädiktionsschritt 34 - gemäß Schritt 38 - wird zunächst ein unkorrigierter kalmanbasierter Zustandsvektor $\hat{x}_{\tilde{a}}(k_i)$, der auch "a priori" Zustandsvektor genannt wird, mit der Zustandsgleichung der Kalman-Filterung

$$\hat{x}_{\tilde{a}}(k_i) = F(k_i) \cdot \hat{x}(k_{i-1}) + u(k_i)$$

ermittelt. Der aktuelle unkorrigierte kalmanbasierte Zustandsvektor $\hat{x}_{\tilde{a}}(k_i)$ wird hier durch eine Multiplikation des kaimanbasierten Zustandsvektors $\hat{x}(k_{i-1})$, der in dem dem aktuellen Zeitpunkt vorhergehenden Zeitpunkt bestimmten wurde, mit einer aktuellen Übergangsmatrix $F(k_i)$ erhalten. Der im vorhergehenden Zeitpunkt bestimmte kalmanbasierter Zustandsvektor $\hat{x}(k_{i-1})$ wurde für diese Ermittlung - gemäß Schritt 40 - in einem vorhergehenden Iterationsschritt abgespeichert. Der Term $u(k)$, der den deterministischen Anteil der Zustandsgleichung des Kalman-Filters beschreibt, ist hier zwar dargestellt, wobei dieser nicht weiter erläutert wird, da dieser später gemäß der Erfindung zu Null gesetzt wird. Ferner wird im Prädiktionsschritt 34 bei der Kalman-Filterung die Kovarianzmatrix des Schätzfehlers des aktuellen unkorrigierten kaimanbasierten Zustandsvektors $\hat{x}_{\tilde{a}}(k_i)$ - gemäß Schritt 42 - mit

$$\hat{P}_{\tilde{a}}(k_i) = F(k_i) \cdot \hat{P}(k_{i-1}) \cdot F^T(k_i) + Q$$

ermittelt. $F^T(k_i)$ ist hierbei die transponierte aktuelle Übergangsmatrix $F(k_i)$ und $\hat{P}(k_{i-1})$ ist die Kovarianzmatrix des Schätzfehlers des kaimanbasierten Zustandsvektors $\hat{x}(k_{i-1})$, der im Zeitpunkt $k_{i-1}$ vor dem aktuellen Zeitpunkt $k_i$ ermittelt wurde. Diese Kovarianzmatrix $\hat{P}(k_{i-1})$ wird jeweils, wie weiter unten beschrieben, am Ende des jeweiligen Korrekturschritts 36 für einen aktuellen kaimanbasierten Zustandsvektor $\hat{x}$ zur Verwendung im darauffolgenden Iterationsschritt ermittelt und abgespeichert - Schritt 44.

Ferner wird eine Kovarianzmatrix Q eines Prozessrauschens berücksichtigt, um die bislang idealisierten Annahmen durch eine Fehlermodellierung an die realen Bedingungen anzugleichen. Diese Kovarianzmatrix Q wurde für ein hier angenommenes Prozessrauschen vorbestimmt - Schritt 46.

Im Korrekturschritt 36 werden nun Sensordaten bzw. Sensordaten der Sensoren der Segmente 22 der Schleppantenne 12 betrachtet. Wie bereits oben erläutert, weist ein bzw. weisen mehrere der Segmente jeweils einen oder mehrere Sensoren zur Ermittlung von Messwerten $\vartheta$ der Messgrößen Position, Ausrichtung und/oder Form des jeweiligen Segments 22 auf. Die Messwerte $\vartheta$ der gleichen Messgröße werden dann zum gleichen Zeitpunkt $k_i$ in einem Messvektor $z(k_i)$ dargestellt - Schritt 48. Beispielhaft wird hier davon ausgegangen, dass jedes Segment 22 der Schleppantenne 12 genau einen Sensor aufweist. Jeder Sensor nimmt Messwerte $\vartheta$, hier beispielhaft Kompasswerte $\vartheta$, also die Ausrichtung des jeweiligen Segments 22 zum Erdmagnetfeld, auf. Werden die Segmente 22 aus Fig. 1 betrachtet und die Messwerte der Segmente 22 durch die Indizes 1 bis 9 indiziert, so ist ein Messvektor $z(k_i)$ eines aktuellen Zeitpunktes $k_i$ durch

$$z(k_i) = \begin{bmatrix} \vartheta_1(k) \\ \vartheta_2(k) \\ \dots \\ \dots \\ \vartheta_9(k) \end{bmatrix}.$$

darstellbar. Dieser aktuelle Messvektor $z(k_i)$ wird nun im Korrekturschritt 36 zur Korrektur des aktuellen unkorrigierten kalmanbasierten Zustandsvektors $\hat{x}_{\tilde{a}}(k_i)$ genutzt. Zur Korrektur 50 des aktuellen unkorrigierten kalmanbasierten Zustandsvektors $\hat{x}_{\tilde{a}}(k_i)$ wird die Differenz zwischen dem Messvektor $z(k_i)$ und dem aktuellen unkorrigierten kalmanbasierten Zustandsvektor $\hat{x}_{\tilde{a}}(k_i)$ ermittelt. Diese Differenz wird durch Multiplikation mit einer aktuellen Kalman-Matrix $\hat{K}(k_i)$ gewichtet. Das gewichtete Ergebnis wird dann zum aktuellen unkorrigierten kalmanbasierten Zustandsvektor $\hat{x}_{\tilde{a}}(k_i)$ hinzuaddiert. Die Korrektur erfolgt also durch

$$\hat{x}(k_i) = \hat{x}_{\tilde{a}}(k_i) + \hat{K}(k_i) \cdot (z(k_i) - H \cdot \hat{x}_{\tilde{a}}(k_i)),$$

wodurch der aktuelle kalmanbasierte Zustandsvektor $\hat{x}(k_i)$ erhalten wird. Hier bezeichnet H eine bei der Kalman-Filterung als Beobachtungsmatrix oder Messmatrix bezeichnete Matrix. Diese Messmatrix H dient zur Abbildung der Zustandsgrößen aus dem kalmanbasierten Zustandsvektor $\hat{x}(k_i)$ auf die mit den Sensoren erfassten Messgrößen. Für das o.g. Beispiel mit jeweils einem Sensor pro Segment würde die Messmatrix H der Einheitsmatrix entsprechen.

Die oben im Korrekturschritt 36 benutzte aktuelle Kalman-Matrix $\hat{K}(k_i)$ bestimmt sich nach

$$\hat{K}(k_i) = \hat{P}_{\tilde{a}}(k_i) \cdot H^T (H \cdot \hat{P}_{\tilde{a}}(k_i) \cdot H^T + R)^{-1}$$

und wird vor der Ermittlung des aktuellen kalmanbasierten Zustandsvektors $\hat{x}(k_i)$ ermittelt - Schritt 52. Die Matrix R entspricht hier einer Kovarianzmatrix, die für angenommene Messfehler der Sensoren vorbestimmt - gemäß Schritt 54 - wurde. $H^T$ ist die transponierte Messmatrix H.

Nach der Ermittlung - gemäß Schritt 50 - des aktuellen kalmanbasierten Zustandsvektors $\hat{x}(k_i)$ wird noch die Kovarianzmatrix $\hat{P}(k_i)$ des Schätzfehlers dieses kalmanbasierten Zustandsvektors durch

$$\hat{P}(k_i) = \hat{P}_{\tilde{a}}(k_i) - \hat{K}(k_i) \cdot (H \cdot \hat{P}_{\tilde{a}}(k_i) \cdot H^T + R) \cdot \hat{K}^T(k_i)$$

ermittelt 56. Diese Kovarianzmatrix wird, wie bereits oben beschrieben, zur Ermittlung des folgenden kalmanbasierten Zustandsvektors $\hat{x}(k_{i+1})$, der im nächsten Iterationsschritt nach dem aktuellen kalmanbasierten Zustandsvektor $\hat{x}(k_i)$ ermittelt wird, gespeichert - gemäß Schritt 44.

Zusammenfassend werden also, gemäß der Darstellung in Fig. 3, ein aktueller unkorrigierter kalmanbasierter Zustandsvektor $\hat{x}_{\tilde{a}}(k_i)$ - gemäß Schritt 38 - ermittelt. Ferner wird die Kovarianzmatrix Q eines angenommenen Prozessrauschens - gemäß Schritt 46 - vorbestimmt. Daraufhin wird die Kovarianzmatrix des Schätzfehlers des aktuellen unkorrigierten kalmanbasierten Zustandsvektors $\hat{x}_{\tilde{a}}(k_i)$ - gemäß Schritt 42 - ermittelt. Ferner wird die Kovarianzmatrix R durch angenommene Messfehler der Sensoren - gemäß Schritt 54 - vorbestimmt und die Kalman-Matrix - gemäß Schritt 52 - ermittelt. Die Messwerte $\vartheta$ der Sensoren werden als Messvektor $z(k_i)$ - gemäß Schritt 48 - dargestellt und mit dem Messvektor $z(k_i)$ und der Kalman-Matrix $\hat{K}(k_i)$ der aktuelle kalmanbasierten Zustandsvektors $\hat{x}(k_i)$ - gemäß Schritt 50 - ermittelt. Der aktuelle kalmanbasierten Zustandsvektors $\hat{x}(k_i)$ wird dann - gemäß Schritt 40 - abgespeichert und die Kovarianzmatrix $\hat{P}(k_i)$ seines Schätzfehlers für den darauffolgenden Iterationsschritt - gemäß Schritt 56 - bestimmt.

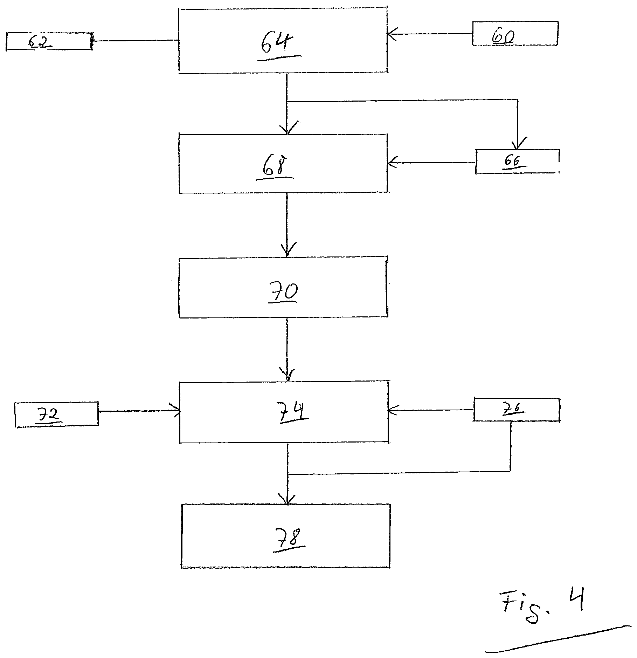

Fig. 4 zeigt den Ablauf eines Ausführungsbeispiels des erfindungsgemäßen Verfahrens. Bei dem Verfahren wird zunächst ein mechanisches Modell 24 ausgewählt oder - gemäß Schritt 60 - bestimmt, das die Schleppantenne 12, deren Form geschätzt werden soll, hinreichend genau abbildet. Ein derartiges Modell wurde in Fig. 2 dargestellt. Dann wird die Bewegung des Zugpunktes 16 bestimmt - gemäß Schritt 62 - und aus der Zugpunktbewegung und dem mechanischen Modell 24 ein aktueller modellbasierter Zustandsvektor $x(k_i)$ eines aktuellen Zeitpunktes $k_i$, wie in der Beschreibung zu Fig. 2 dargestellt, ermittelt - Schritt 64. Ist der aktuelle Zeitpunkt $k_i$ ein erster zu betrachtender Zeitpunkt $k_0$, so wird der ermittelte aktuelle modellbasierte Zustandsvektor $x(k_0)$ lediglich - gemäß Schritt 66 - gespeichert und das Verfahren geht in den nächsten Iterationsschritt über. Geht man von einem aktuellen Zeitpunkt $k_i$ aus, der nicht dem Zeitpunkt $k_0$ entspricht, so wird mit dem aktuellen modellbasierten Zustandsvektor $x(k_i)$ und einem im vorhergehenden Iterationsschritt zuvor gespeicherten modellbasierten Zustandsvektor $x(k_{i\text{-}1})$ eine aktuelle Matrix $\tilde{F}(k_i)$ bestimmt bzw. - gemäß Schritt 68 - geschätzt.

Die aktuelle Matrix $\tilde{F}(k_i)$ wird dann in die Übergangsmatrix $F(k_i)$ - gemäß Schritt 70 - überführt. Eine Überführung - gemäß Schritt 70 - ist hier nötig, wenn die Werte der bei der folgenden Kalman-Filterung betrachteten kaimanbasierten Zustandsvektoren $\hat{x}(k_i)$ und Messvektoren $z(k_i)$ zu den modellierten Zustandsvektoren $x(k_i)$ unterschiedliche Messgrößen beschreiben. Ein Beispiel hierfür wäre, wenn etwa die kaimanbasierten Zustandsvektoren $\hat{x}(k_i)$ und Messvektoren $z(k_i)$ die Ausrichtungen mehrerer oder aller der Segmente beschreiben, während die Werte der modellbasierten Zustandsvektoren $x(k_i)$ die absoluten Positionen mehrerer oder aller der Segmente beschreiben. Bei diesem Beispiel müsste z.B. die Form der Schleppantenne anhand der bekannten Positionen der Segmente ermittelt und sich daraus ergebende Kompasswerte, also die Ausrichtungen, der Segmente bei einer derartigen Form bestimmt werden. Hiermit kann dann die aktuelle Matrix $\tilde{F}(k_i)$ in eine aktuelle Übergangsmatrix $F(k_i)$ - gemäß Schritt 70 - überführt werden.

Im nächsten Schritt werden dann Messwerte von Sensoren der Schleppantenne 12, z.B. von Tiefensensoren oder Kompassen, aufgenommen - Schritt 72. Für einen aktuellen Zeitpunkt $k_i$ wird dann mit einer Kalman-Filterung ein aktueller kaimanbasierten Zustandsvektor $\hat{x}(k_i)$ - gemäß Schritt 74 - bestimmt. Hierfür wird die aus dem mechanischen Modell 24 erhaltene aktuelle Übergangsmatrix $F(k_i)$, der aus den Messwerten der Sensoren erhaltene aktuelle Messvektore $z(k_i)$ und ein gespeicherter kalmanbasierter Zustandsvektor $\hat{x}(k_{i\text{-}1})$ des Zeitpunktes $k_{i\text{-}1}$, der vor dem aktuellen Zeitpunkt $k_i$ ermittelt wurde, herangezogen. Nach der Bestimmung des aktuellen kaimanbasierten Zustandsvektors $\hat{x}(k_i)$ wird dieser für die Ermittlung des zeitlich folgenden Zustandsvektors $\hat{x}(k_{i+1})$ des folgenden Zeitpunktes $k_{i+1}$ - gemäß Schritt 76 - gespeichert. Aus den Werten des aktuellen kaimanbasierten Zustandsvektors $\hat{x}(k_i)$, die z.B. die aktuellen Positionen, Ausrichtungen und/oder Formen mehrerer oder aller der Segmente 22 beschreiben, wird dann die aktuelle Form der Schleppantenne 12 - gemäß Schritt 78 - geschätzt.

Somit ist eine Schätzung der Form einer Schleppantenne 12 mit einer Kaiman-Filterung möglich, da die mit einem mechanischen Modell 24 bestimmte Übergangsmatrix $F(k_i)$ wiederholt aktualisiert wird und daher beliebige, auch inhomogene, physikalische Eigenschaften der Segmente der Schleppantenne betrachtbar sind. Zudem kann der Zugpunkt der Schleppantenne an einer beliebigen Position und eine beliebige zeitliche Bewegung der Schleppantenne angenommen werden.

Alle in der vorstehenden Beschreibung und in den Ansprüchen genannten Merkmale sind sowohl einzeln als auch in beliebiger Kombination miteinander einsetzbar. Die Offenbarung der Erfindung ist daher nicht auf die beschriebene bzw. beanspruchte Merkmalskombination beschränkt. Vielmehr sind alle Merkmalskombinationen als offenbart zu betrachten.


**Patentansprüche**

1. Verfahren zum Schätzen der Form einer akustischen Schleppantenne (12), wobei die Form mit einer Kalman-Filterung geschätzt wird, der deterministische Anteil ($u(k_i)$) der Zustandsgleichung des Kalman-Filters zu Null gesetzt wird, aufeinanderfolgende diskrete Zeitpunkte ($k_i$) vordefiniert werden und in den vordefinierten Zeitpunkten ($k_i$) jeweils eine geschätzte Form der Schleppantenne (12) durch einen modellbasierten Zustandsvektor ($x(k_i)$) beschrieben wird, **dadurch gekennzeichnet, dass** die modellbasierten Zustandsvektoren ($x(k_i)$) durch das geschätzte zeitliche Verhalten eines mechanischen Modells (24) der Schleppantenne (12) und durch als bekannt vorausgesetzte Bewegungen eines Zugpunktes (16) der Schleppantenne (12) ermittelt werden, die Abweichung des aktuellen modellbasierten Zustandsvektors ($x(k_i)$) zu einem oder mehreren vorhergehenden modellbasierten Zustandsvektoren ($x(k_{i\text{-}1})$) bestimmt und als eine aktuelle Matrix ($\tilde{F}(k_i)$) betrachtet wird und die aktuelle Übergangsmatrix ($F(k_i)$) für die Kalman-Filterung mit den ermittelten Matrizen ($\tilde{F}(k_i)$) periodisch aktualisiert wird.

2. Verfahren nach Anspruch 1,
   **dadurch gekennzeichnet, dass**
   die Schleppantenne (12) als in mehrere Segmente (22) eingeteilt angenommen wird und mit der Kalman-Filterung kaimanbasierte Zustandsvektoren ($\hat{x}(k_i)$) periodisch ermittelt werden, wobei jeder kaimanbasierte Zustandsvektor ($\hat{x}(k_i)$) jeweils mit der Kalman-Filterung geschätzte Werte aufweist, die aktuelle Positionen, Ausrichtungen und/oder Formen mehrerer oder aller der Segmente (22) beschreiben.

3. Verfahren nach Anspruch 1 oder 2,
   **dadurch gekennzeichnet, dass**
   bei der Kalman-Filterung ein aktueller kalmanbasierter Zustandsvektor ($\hat{x}(k_i)$) mit einem Prädiktionsschritt (34) und einem auf den Prädiktionsschritt (34) folgenden Korrekturschritt (36) ermittelt wird, wobei im Prädiktionsschritt (34) ein aktueller unkorrigierter kalmanbasierter Zustandsvektor ($\hat{x}_{\tilde{a}}(k_i)$) durch Multiplikation eines oder mehreren vorher

bestimmter kalmanbasierter Zustandsvektoren ($\hat{x}(k_{i-1})$) mit der Übergangsmatrix ($F(k_i)$) ermittelt wird und der aktuelle unkorrigierte kaimanbasierte Zustandsvektor ($\hat{x}_a^-(k_i)$) im Korrekturschritt (36) in den aktuellen kalmanbasierten Zustandsvektor ($\hat{x}(k_i)$) überführt wird.

**4.** Verfahren nach Anspruch 3,
**dadurch gekennzeichnet, dass**
eines oder mehrere der Segmente (22) jeweils einen oder mehrere Sensoren zur Ermittlung von Messwerten ($\vartheta$) der Messgrößen Position, Ausrichtung und/oder Form des jeweiligen Segments (22) aufweisen, wobei die Messwerte ($\vartheta$) der gleichen Messgröße zum gleichen Zeitpunkt ($k_i$) in einem Messvektor ($z(k_i)$) dargestellt werden, und im Korrekturschritt (36) der aktuelle kaimanbasierte Zustandsvektor ($\hat{x}(k_i)$) ermittelt wird, indem die Differenz zwischen dem Messvektor ($z(k_i)$) und dem aktuellen unkorrigierten kaimanbasierten Zustandsvektor ($\hat{x}_a^-(k_i)$) ermittelt, durch Multiplikation mit der aktuellen Kalman-Matrix ($F(k_i)$) gewichtet und das Produkt durch Addition mit dem aktuellen unkorrigierten kaimanbasierten Zustandsvektor ($\hat{x}_a^-(k_i)$) in den aktuellen kaimanbasierte Zustandsvektor ($\hat{x}(k_i)$) überführt wird.

**5.** Verfahren nach einem der vorherigen Ansprüche,
**dadurch gekennzeichnet, dass**
die aktuelle Kalman-Matrix ($\hat{K}(k_i)$) mit der Kovarianzmatrix des Schätzfehlers ($\hat{P}_a^-(k_i)$) des aktuellen unkorrigierten kaimanbasierten Zustandsvektors ermittelt ($\hat{x}_a^-(k_i)$) wird, wobei die Kovarianzmatrix ($\hat{P}_a^-(k_i)$) des Schätzfehlers des aktuellen unkorrigierten kalmanbasierter Zustandsvektors ($\hat{x}_a^-(k_i)$) mit der aktuellen Übergangsmatrix ($F(k_i)$) und der Kovarianzmatrix ($\hat{P}(k_{i-1})$) des Schätzfehlers des zuvor ermittelten kalmanbasierten Zustandsvektors ($\hat{x}(k_{i-1})$) ermittelt wird.

**6.** Verfahren nach Anspruch 5,
**dadurch gekennzeichnet, dass**
Störungen der Sensoren mit dadurch fehlerbehafteten Messwerten ($\vartheta$) der Sensoren angenommen werden, eine Kovarianzmatrix ($R$) dieser Messfehler der Messwerte ($\vartheta$) der Sensoren zu Beginn der Schätzung einmalig oder in vordefinierten Intervallen bestimmt wird und diese Kovarianzmatrix ($R$) zur Ermittlung der Kalman-Matrix ($\hat{K}(k_i)$) herangezogen wird.

**7.** Verfahren nach Anspruch 6,
**dadurch gekennzeichnet, dass**
die Messwerte der Sensoren geglättet werden.

**8.** Verfahren nach einem der Ansprüche 5 bis 7,
**dadurch gekennzeichnet, dass**
eine Kovarianzmatrix ($Q$) eines angenommenen additiven Prozessrauschens einmalig zu Beginn der Formschätzung oder in vordefinierten Intervallen bestimmt wird und zur Ermittlung der Kovarianzmatrix ($\hat{P}_a^-(k_i)$) des Schätzfehlers des jeweiligen aktuellen unkorrigierten kaimanbasierten Zustandsvektors ($\hat{x}_a^-(k_i)$) herangezogen wird.

**9.** Verfahren nach einem der vorherigen Ansprüche,
**dadurch gekennzeichnet, dass**
ein erster kalmanbasierter Zustandsvektor ($\hat{x}(k_0)$) zur Bestimmung darauffolgender kalmanbasierter Zustandsvektoren (($\hat{x}(k_i)$) und ein erster modellbasierte Zustandsvektor ($x(k_0)$) zu Bestimmung darauffolgender modellbasierter Zustandsvektoren ($x(k_i)$) anhand einer vermuteten Form der Schleppantenne (12) zu Beginn der Schätzung ermittelt werden.

**10.** Verfahren nach einem der vorherigen Ansprüche,
**dadurch gekennzeichnet, dass**
das mechanische Modell (24) der Schleppantenne (12) ein Feder-Masse-System berücksichtigt, bei dem ein oder mehrere Punkte, z.B. Schwerpunkte oder ein oder mehrer beliebige andere Punkte, jeweils für jedes Segment (22) der Schleppantenne (12) als Masse ($m$) und benachbarte Massen ($m$) als durch Federn (28) miteinander verbunden betrachtet werden und das geschätzte zeitliche Verhalten des mechanischen Modells (24) der Schleppantenne (12) durch die Beschleunigungen der Massen ($m$) ermittelt wird, wobei die Beschleunigungen durch die Zugkräfte (30a, 30b) der Federn (28) sowie durch äußere Kräfteeinwirkungen auf das Feder-Masse-System, insbesondere durch angenommene hydrodynamische Kräfte, angenommene, durch verdrängte Flüssigkeit verursachte Gegenkräfte sowie angenommene statische Auftriebskräfte, beschrieben werden.

**11.** Verfahren nach einem der vorherigen Ansprüche,
**dadurch gekennzeichnet, dass**
zyklische Werte der modellbasierten Zustandsvektoren ($x(k_i)$), wie z.B. geschätzte Kompasswerte der Segmente (22), vor der Bestimmung der aktuellen Übergangsmatrix ($F(k_i)$) sowie zyklische Messwerte ($\vartheta$) der Messvektoren ($z(k_i)$) vor der Bestimmung der Abweichung zwischen dem jeweiligen Messvektor ($z(k_i)$) und dem aktuellen unkorrigierten kalmanbasierten Zustandsvektor ($\tilde{x}_a^-(k_i)$) in äquivalente lineare Werte bzw. Messwerte ($\vartheta$) überführt werden.

**12.** Verfahren nach einem der vorherigen Ansprüche,
**dadurch gekennzeichnet, dass**
der zeitliche Abstand ($\Delta t$) zwischen den definierten Zeitpunkten ($k_i$) kürzer ist als der zeitliche Abstand zwischen den Zeitpunkten, in denen die Position des Zugpunktes (16) ermittelt wird, und aktuelle Positionen des Zugpunktes (16), die zeitlich zwischen den ermittelten Zeitpunkten liegen, durch Interpolation ermittelt werden.

**13.** Verfahren nach einem der vorherigen Ansprüche,
**dadurch gekennzeichnet, dass**
kaimanbasierte Zustandsvektoren (($\hat{x}(k_i)$) mit einer geringeren Wiederholrate ermittelt werden als modellbasierte Zustandsvektoren ($x(k_i)$).

**14.** Verfahren nach einem der vorherigen Ansprüche,
**dadurch gekennzeichnet, dass**
die modellbasierten Zustandsvektoren ($x(k_i)$) und die kaimanbasierten Zustandsvektoren (($\hat{x}(k_i)$) nur diskrete Werte geschätzter Positionen, Ausrichtungen und/oder Formen oder aus diesen Werten abgeleitete Werte aufweisen.

**15.** Vorrichtung zur Schätzung der Form eine akustischen Schleppantenne (12), wobei die Vorrichtung derart ausgebildet ist, um die Form mit einem Mittel zur Kalman-Filterung zu schätzen,
wobei
die Vorrichtung ferner derart ausgebildet ist, um den deterministischen Anteil ($u(k_i)$) der Zustandsgleichung des Kalman-Filters zu Null zu setzen, aufeinanderfolgende diskrete Zeitpunkte ($k_i$) vorzudefinieren und in den vordefinierten Zeitpunkten ($k_i$) jeweils eine geschätzte Form der Schleppantenne (12) durch einen modellbasierten Zustandsvektor ($x(k_i)$) zu beschreiben, **dadurch gekennzeichnet, dass** die Vorrichtung derart ausgebildet ist, um die modellbasierten Zustandsvektoren ($x(k_i)$) durch das geschätzte zeitliche Verhalten eines mechanischen Modells (24) der Schleppantenne (12) und durch als bekannt vorausgesetzte Bewegungen eines Zugpunktes (16) der Schleppantenne (12) zu ermitteln, die Abweichung des aktuellen modellbasierten Zustandsvektors ($x(k_i)$) zu einem oder mehreren vorhergehenden modellbasierten Zustandsvektoren ($x(k_{i-1})$) zu bestimmen, diese Abweichungen jeweils als eine aktuelle Matrix ($\tilde{F}(k_i)$) zu betrachten und die aktuelle Übergangsmatrix ($F(k_i)$) des Kalman-Filters mit den ermittelten Matrizen ($\tilde{F}(k_i)$) periodisch zu aktualisieren.

## Claims

**1.** Method for estimating the shape of an acoustic trailing aerial (12), wherein the shape is estimated with a Kalman filtering, the deterministic component ($uk_i$)) of the equation of state of the Kalman filter is set to null, successive, discrete points in time ($k_i$) are predefined and an estimated shape of the trailing aerial (12) is described by a model-based state vector ($x(k_i)$) at the predefined points in time ($k_i$), **characterized by that** the model-based state vectors ($x(k_i)$ are determined by the estimated behaviour of a mechanical model (24) of the trailing aerial (12) in time and by movements of a traction point (16) of the trailing aerial (12) which are assumed as known, the deviation of the current model-based state vector ($x(k_i)$ from one or more previous model-based state vectors ($x(k_i)$ is determined and is considered as a current matrix ($\tilde{F}(k_i)$) and the current transitional matrix ($F(k_i)$) is periodically updated for the Kalman filtering with the determined matrices ($\tilde{F}(k_i)$).

**2.** Method according to Claim 1,
**characterized by that**
the trailing aerial (12) is assumed to be divided into several segments (22) and is periodically determined with the Kalman filtering Kalman-based state vectors ($\hat{x}(k_i)$), wherein each Kalman-based state vector ($\hat{x}(k_i)$) comprises values estimated with the Kalman filtering and which describe the current positions, alignments and/or shapes of several or all of the segments (22).

**3.** Method according to Claim 1 or 2,

**characterized by that**
in the Kalman filtering a current, Kalman-based state vector ($\hat{x}(k_i)$) is determined with a prediction step (34) and a correction step (36) following the prediction step (34), wherein in the prediction step (34) a current, uncorrected, Kalman-based state vector ($\hat{x}_a^-(k_i)$) is determined by multiplication of one or more previously determined, Kalman-based state vectors ($\hat{x}(k_{i-1})$) with the transitional matrix ($F(k_i)$) and the current, uncorrected, Kalman-based state vector ($\hat{x}_a^-(k_i)$) is transferred in correction step (36) is transferred into the current Kalman-based state vector ($\hat{x}(k_i)$).

4. The method according to Claim 3,
**characterized by that**
one or more of the segments (22) comprise one or more sensors for determining measured values ($\vartheta$) of the measuring magnitudes position, alignment and/or shape of the particular segment (22), wherein the measured values ($\vartheta$) of the same measuring magnitude are shown at the same point in time ($k_i$) in a measuring vector ($z(k_i)$), and the current, Kalman-based state vector ($\hat{x}(k_i)$) is determined in the correction step (36) in that the difference between the measuring vector ($z(k_i)$) and the current, uncorrected, Kalman-based state vector ($\hat{x}_a^-(k_i)$) is determined, weighted by multiplication by the current Kalman matrix ($F(k_i)$) and the product is transferred by addition to the current, uncorrected, Kalman-based state vector ($\hat{x}_a^-(k_i)$) into the current, Kalman-based state vector. ($\hat{x}(k_i)$)

5. Method according to any one of the previous claims,
**characterized by that**
the current Kalman matrix ($\hat{K}(k_i)$) is determined ($\hat{x}_a^-(k_i)$) with the covariance matrix of the estimated error ($\hat{P}_a^-(k_i)$) of the current, uncorrected, Kalman-based state vector, wherein the covariance matrix ($\hat{P}_a^-(k_i)$) of the estimated error of the current, uncorrected, Kalman-based state vector ($\hat{x}_a^-(k_i)$) is determined with the current transitional matrix ($F(k_i)$) and the covariance matrix ($\hat{P}(k_{i-1})$) of the estimated error of the previously determined, Kalman-based state vector ($\hat{x}(k_{i-1})$).

6. Method according to Claim 5,
**characterized by that**
disturbances of the sensors are assumed with measured values ($\vartheta$) of the sensors which contain errors as a result thereof, a covariance matrix (R) of these measured errors of the measured values ($\vartheta$) of the sensors is determined once at the beginning of the estimation or at predefined intervals and this covariance matrix (R) is used to determine the Kalman matrix ($\hat{K}(k_i)$).

7. Method according to Claim 6,
**characterized by that**
the measured values of the sensors are smoothed.

8. Method according to one of Claims 5 to 7,
**characterized by that**
a covariance matrix (Q) of a received, additive process noise is determined once at the beginning of the estimation of shape or at predetermined intervals and is used to determine the covariance matrix ($\hat{P}_a^-(k_i)$) of the estimated error of the particular current, uncorrected, Kalman-based state vector ($\hat{x}_a^-(k_i)$).

9. Method according to one of the previous claims,
**characterized by that**
a first Kalman-based state vector ($\hat{x}(k_0)$) is determined for determining subsequent, Kalman-based state vectors (($\hat{x}(k_i)$)) and a first model-based state vector ($\hat{x}(k_0)$) is determined for determining subsequent model-based state vectors ($x(k_i)$) using an assumed shape of the trailing aerial (12) at the beginning of the estimation.

10. Method according to one of the previous claims,
**characterized by that**
the mechanical model (24) of the trailing aerial (12) takes into account a spring mass system in which one or more points, e.g., centres of gravity or one or more of any other points are considered as mass ($m$) and adjacent masses ($m$) as connected to each other by springs (28) for each segment (22) of the trailing aerial (12) and the estimated behaviour of the mechanical model (24) of the trailing aerial (12) in time is determined by the accelerations of the masses ($m$), wherein the accelerations are described by the attractive forces (30a, 30b) of the springs (28) as well as by external actions of forces acting on the spring-mass system, in particular by received hydrodynamic forces, received counterforces caused by displaced liquid, and received static buoyancy forces.

**11.** Method according to one of the previous claims,
**characterized by that**
cyclic values of the model-based state vectors ($x(k_i)$) such as, e.g., estimated compass values of the segments (22) prior to the determination of the current transitional matrix ($F(k_i)$) and cyclic measured values ($\vartheta$) of the measuring vectors ($z(k_i)$) prior to the determination of the deviation between the particular measuring vector ($z(k_i)$) and the current, uncorrected, Kalman -based state vector ($\hat{x}_a^-(k_i)$) are converted into equivalent, linear values or measured values ($\vartheta$).

**12.** Method according to one of the previous claims,
**characterized by that**
the time interval ($\Delta t$) between the defined time points ($k_i$) is shorter than the time interval between the time points in which the position of the traction point (16) is determined, and actual positions of the traction point (16) which are located in time between the determined time points are determined by interpolation.

**13.** Method according to one of the previous claims,
**characterized by that**
Kalman-based state vectors ($\hat{x}(k_i)$) are determined at a lesser repetition rate than model-based state vectors ($x(k_i)$).

**14.** Method according to one of the previous claims,
**characterized by that**
the model-based state vectors ($x(k_i)$) and the Kalman-based state vectors ($\hat{x}(k_i)$) have only discrete values of estimated positions, alignments and/or shapes or values derived from these values.

**15.** Device for estimating the shape of an acoustic trailing aerial (12), wherein the device is constructed so as to estimate the shape with a means for Kalman filtering,
wherein
the device is furthermore designed to set the deterministic component ($u(k_i)$) of the equation of state of the Kalman filter to null, to predefine successive, discrete points in time ($k_i$) and to describe an estimated shape of the trailing aerial (12) by a model-based state vector ($x(k_i)$) at the predefined points in time ($k_i$), **characterized by that** the device is designed to determine the model-based state vectors ($x(k_i)$) by the estimated behaviour in time of a mechanical model (24) of the trailing aerial (12) and by movements of a traction point (16) of the trailing aerial (12) which are assumed as known, to determine the deviation of the current, model-based state vector ($x(k_i)$) from one or more previous, model-based state vectors ($x(k_{i-1})$), to consider these deviations as a current matrix ($\tilde{F}(k_i)$) and to periodically update the current transitional matrix ($F(k_i)$) of the Kalman filter with the determined matrices ($\tilde{F}(k_i)$).

**Revendications**

**1.** Procédé d'estimation de la forme d'une antenne remorquée (12) acoustique, la forme étant estimée au moyen d'un filtrage de Kalman, la composante déterministe ($u(k_i)$) de l'équation d'état du filtre de Kalman étant posée égale à zéro, des instants discrets ($k_i$) successifs étant prédéfinis et, dans les instants prédéfinis ($k_i$), une forme estimée de l'antenne remorquée (12) étant respectivement décrite par un vecteur d'état basé sur un modèle ($x(k_i)$), **caractérisé en ce que** les vecteurs d'état basés sur un modèle ($x(k_i)$) sont déterminés par le comportement dans le temps estimé d'un modèle mécanique (24) de l'antenne remorquée (12) et par des déplacements supposés connus d'un point de traction (16) de l'antenne remorquée (12), l'écart entre le vecteur d'état actuel basé sur un modèle ($x(k_i)$) et un ou plusieurs vecteurs d'état précédents basés sur un modèle ($x(k_{i-1})$) est déterminé et considéré sous la forme d'une matrice actuelle ($\tilde{F}(k_i)$) et la matrice de transition ($F(k_i)$) actuelle est mise à jour périodiquement avec les matrices déterminées ($\tilde{F}(k_i)$) pour le filtrage de Kalman.

**2.** Procédé selon la revendication 1,
**caractérisé en ce que**
l'antenne remorquée (12) est supposée divisée en plusieurs segments (22) et des vecteurs d'état basés sur le filtrage de Kalman ($\hat{x}(k_i)$) sont déterminés périodiquement au moyen du filtrage de Kalman, chaque vecteur d'état basé sur le filtrage de Kalman ($\hat{x}(k_i)$) comportant respectivement des valeurs estimées au moyen du filtrage de Kalman, qui décrivent des positions, orientations et/ou formes actuelles de plusieurs ou de tous les segments (22).

**3.** Procédé selon la revendication 1 ou 2,
**caractérisé en ce que,**

lors du filtrage de Kalman, un vecteur d'état actuel basé sur le filtrage de Kalman ($\hat{x}(k_i)$) est déterminé au moyen d'une étape de prédiction (34) et d'une étape de correction (36) suivant l'étape de prédiction (34), un vecteur d'état actuel non corrigé basé sur le filtrage de Kalman ($\hat{x}_{\tilde{a}}(k_i)$) étant déterminé dans l'étape de prédiction (34) par la multiplication d'un ou de plusieurs vecteurs d'état basés sur le filtrage de Kalman déterminés précédemment ($\hat{x}(k_{i-1})$) avec la matrice de transition ($F(k_i)$) et le vecteur d'état actuel non corrigé basé sur le filtrage de Kalman ($\hat{x}_{\tilde{a}}(k_i)$) étant transformé en vecteur d'état actuel basé sur le filtrage de Kalman ($\hat{x}(k_i)$) dans l'étape de correction (36).

**4.** Procédé selon la revendication 3,
**caractérisé en ce que**
un ou plusieurs des segments (22) comportent respectivement un ou plusieurs capteurs destinés à déterminer des valeurs de mesure ($\vartheta$) des grandeurs de mesure position, orientation et/ou forme du segment (22) respectif, les valeurs de mesure ($\vartheta$) de la même grandeur de mesure au même instant ($k_i$) étant représentées dans un vecteur de mesure ($z(k_i)$), et le vecteur d'état actuel basé sur le filtrage de Kalman ($x(k_i)$) étant déterminé dans l'étape de correction (36) en déterminant la différence entre le vecteur de mesure ($z(k_i)$) et le vecteur d'état actuel non corrigé basé sur le filtrage de Kalman ($\hat{x}_{\tilde{a}}(k_i)$, en la pondérant par la multiplication avec la matrice de Kalman actuelle ($F(k_i)$) et en transformant le produit en vecteur d'état actuel basé sur le filtrage de Kalman ($\hat{x}(k_i)$) par l'addition avec le vecteur d'état actuel non corrigé basé sur le filtrage de Kalman ($\hat{x}_{\tilde{a}}(k_i)$).

**5.** Procédé selon l'une des revendications précédentes,
**caractérisé en ce que**
la matrice de Kalman actuelle ($\hat{K}(k_i)$) est déterminée au moyen de la matrice de covariance de l'erreur d'estimation ($\hat{P}_{\tilde{a}}(k_i)$) du vecteur d'état actuel non corrigé basé sur le filtrage de Kalman ($\hat{x}_{\tilde{a}}(k_i)$), la matrice de covariance ($\hat{P}_{\tilde{a}}(k_i)$) de l'erreur d'estimation du vecteur d'état actuel non corrigé basé sur le filtrage de Kalman ($\hat{x}_{\tilde{a}}(k_i)$) étant déterminé au moyen de la matrice de transition actuelle ($F(k_i)$) et la matrice de covariance ($\hat{P}(k_{i-1})$) de l'erreur d'estimation du vecteur d'état basé sur le filtrage de Kalman déterminé précédemment ($\hat{x}(k_{i-1})$).

**6.** Procédé selon la revendication 5,
**caractérisé en ce que**
des perturbations des capteurs sont supposées avec de ce fait des valeurs de mesure ($\vartheta$) erronées des capteurs, une matrice de covariance ($R$) de ces erreurs de mesure des valeurs de mesure ($\vartheta$) des capteurs est déterminée une fois au début de l'estimation ou à intervalles prédéfinis et cette matrice de covariance ($R$) est mise à contribution pour la détermination de la matrice de Kalman ($\hat{K}(k_i)$).

**7.** Procédé selon la revendication 6,
**caractérisé en ce que**
les valeurs de mesure des capteurs sont lissées.

**8.** Procédé selon l'une des revendications 5 à 7,
**caractérisé en ce que**
une matrice de covariance ($Q$) d'un bruit de procédé supplémentaire supposé est déterminée une fois au début de l'estimation de forme ou à intervalles prédéfinis et est mise à contribution pour la détermination de la matrice de covariance ($\hat{P}_{\tilde{a}}(k_i)$) de l'erreur d'estimation du vecteur d'état actuel non corrigé basé sur le filtrage de Kalman ($\hat{x}_{\tilde{a}}(k_i)$) respectif.

**9.** Procédé selon l'une des revendications précédentes,
**caractérisé en ce que,**
au début de l'estimation, à l'aide d'une forme présumée de l'antenne remorquée (12), un premier vecteur d'état basé sur le filtrage de Kalman ($\hat{x}(k_0)$) est déterminé pour la détermination de vecteurs d'état basés sur le filtrage de Kalman suivants (($\hat{x}(k_i)$) et un premier vecteur d'état basé sur un modèle ($x(k_0)$) est déterminé pour la détermination de vecteurs d'état basés sur un modèle suivants ($x(k_i)$).

**10.** Procédé selon l'une des revendications précédentes,
**caractérisé en ce que**
le modèle mécanique (24) de l'antenne remorquée (12) prend en compte un système masse-ressort, dans lequel un ou plusieurs points, par exemple des centres de gravité ou un ou plusieurs autres points arbitraires sont considérés respectivement pour chaque segment (22) de l'antenne remorquée (12) comme masse ($m$) et des masses ($m$) voisines sont considérées comme reliées entre elles par des ressorts (28) et le comportement dans le temps estimé du modèle mécanique (24) de l'antenne remorquée (12) est déterminé par les accélérations des masses ($m$), les accélérations étant décrites par les forces de traction (30a, 30b) des ressorts (28) ainsi que par des effets de force extérieurs agissant sur le système masse-ressort, en particulier par des forces hydrodynamiques supposées, des forces antagonistes supposées provoquées par du liquide déplacé ainsi que des forces statiques de flottabilité supposées.

11. Procédé selon l'une des revendications précédentes,
**caractérisé en ce que**
des valeurs cycliques des vecteurs d'état basés sur un modèle ($x(k_i)$), telles que des valeurs de boussole estimées des segments (22), sont transformées en valeurs linéaires équivalentes avant la détermination de la matrice de transition actuelle ($F(k_i)$) et des valeurs de mesure ($\vartheta$) cycliques des vecteurs de mesure ($z(k_i)$) sont transformées en valeurs de mesure ($\vartheta$) linéaires équivalentes avant la détermination de l'écart entre le vecteur de mesure ($z(k_i)$) respectif et le vecteur d'état actuel non corrigé basé sur le filtrage de Kalman ($\hat{x}_a^-(k_i)$).

12. Procédé selon l'une des revendications précédentes,
**caractérisé en ce que**
le laps de temps ($\Delta t$) entre les instants définis ($k_i$) est plus court que le laps de temps entre les instants auxquels la position du point de traction (16) est déterminée, et des positions actuelles du point de traction (16), qui se trouvent chronologiquement entre les instants déterminés, sont déterminées par interpolation.

13. Procédé selon l'une des revendications précédentes,
**caractérisé en ce que**
des vecteurs d'état basés sur le filtrage de Kalman ($\hat{x}(k_i)$) sont déterminés à une cadence de répétition inférieure à celle des vecteurs d'état basés sur un modèle ($x(k_i)$).

14. Procédé selon l'une des revendications précédentes,
**caractérisé en ce que**
les vecteurs d'état basés sur un modèle ($x(k_i)$) et les vecteurs d'état basés sur le filtrage de Kalman ($\hat{x}(k_i)$) comportent uniquement des valeurs discrètes de positions, orientations et/ou formes estimées, ou des valeurs dérivées de ces valeurs.

15. Dispositif d'estimation de la forme d'une antenne remorquée (12) acoustique, le dispositif étant conçu de manière à estimer la forme à l'aide d'un moyen de filtrage de Kalman,
dans lequel
le dispositif est en outre conçu de manière à poser égale à zéro la composante déterministe ($u(k_i)$) de l'équation d'état du filtre de Kalman, prédéfinir des instants discrets ($k_i$) successifs et, dans les instants prédéfinis ($k_i$), décrire respectivement une forme estimée de l'antenne remorquée (12) par un vecteur d'état basé sur un modèle ($x(k_i)$), **caractérisé en ce que** le dispositif est conçu de manière à déterminer les vecteurs d'état basés sur un modèle ($x(k_i)$) par le comportement dans le temps estimé d'un modèle mécanique (24) de l'antenne remorquée (12) et par des déplacements supposés connus d'un point de traction (16) de l'antenne remorquée (12), déterminer l'écart entre le vecteur d'état actuel basé sur un modèle ($x(k_i)$) et un ou plusieurs vecteurs d'état précédents basés sur un modèle ($x(k_{i-1})$), considérer ces écarts respectivement sous la forme d'une matrice actuelle ($\tilde{F}(k_i)$) et mettre à jour périodiquement la matrice de transition actuelle ($F(k_i)$) du filtre de Kalman avec les matrices déterminées ($\tilde{F}(k_i)$).

Fig. 1

Fig. 2

Fig. 3

| 62 | → | 64 | ← | 60 |

| 72 | → | 74 | ← | 76 |

68 ← 66

70

78

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **D.A. GRAY ; B.D.O. ANDERSON ; R.R. BITMEAD.** Towed Array Shape Estimation Using Kalman-Filters - Theoretical Models. *IEEE Journal of Oceanic Engineering,* 1987, vol. 18 (4), 543-556
- **RILEY et al.** Towed array shape estimation using Kalman filters - experimental investigations. *IEEE Journal of Oceanic Engineering,* 01. Januar 1993, 572-581
- **NEWHALL et al.** Improved estimation of the shape of towed sonar arrays. *Proceedings of the 21st IEEE Instrumentation and measurement technology conference,* 18. Mai 2004, 873-876

- **W. BRANDENBURG.** A Point Mechanical Model for the Dynamics of Towed Arrays. *IEEE International Conference on ICASSP,* 1984, vol. 9, 194-197
- **TICHAVSKI ; WONG.** Quasi-fluid-mechanics-based-Bayesian Cramer-Rao bounds for deformed towed-array direction finding. *IEEE Transyctions on Signal Processing,* 2004, vol. 52 (1), 36-47
- **NIKITAKOS et al.** Towed array shape estimation using multimodel partitioning filters. *IEEE Journal of Oceanic Engineering,* 01. Oktober 1998, 380-384